(19) Europäisches Patentamt / European Patent Office / Office européen des brevets

(11) **EP 4 636 124 A1**

(12) **EUROPEAN PATENT APPLICATION**

(43) Date of publication:
22.10.2025 Bulletin 2025/43

(21) Application number: 25166724.2

(22) Date of filing: 27.03.2025

(51) International Patent Classification (IPC):
*C23C 16/02* (2006.01)    *C23C 16/04* (2006.01)
*C23C 16/18* (2006.01)    *C23C 16/455* (2006.01)

(52) Cooperative Patent Classification (CPC):
C23C 16/0236; C23C 16/04; C23C 16/045;
C23C 16/18; C23C 16/45534

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR

(30) Priority: 28.03.2024 JP 2024054782

(71) Applicant: Kokusai Electric Corp.
Tokyo 1010045 (JP)

(72) Inventor: SANO, Atsushi
Toyama-shi, 939-2393 (JP)

(74) Representative: Verscht, Thomas Kurt Albert
Josephsburgstrasse 88 A
81673 München (DE)

(54) **SUBSTRATE PROCESSING METHOD, METHOD OF MANUFACTURING SEMICONDUCTOR DEVICE, SUBSTRATE PROCESSING APPARATUS AND PROGRAM**

(57) It is possible to selectively form a metal-containing film starting from a specific region on a substrate. There is provided a technique that includes: (a) forming an adsorption promoting layer capable of promoting an adsorption of an organic-containing agent on a substrate by supplying a halogen-containing agent to the substrate; (b) forming a modification layer on the substrate by supplying the organic-containing agent to the substrate; (c) supplying a source material containing a metal element to the substrate; (d) supplying a reactant to the substrate; and (e) forming a metal-containing film in a region of the substrate where the modification layer is not formed, by performing (b), (c) and (d) N times after (a).

EP 4 636 124 A1

## Description

**[Technical Field]**

The present disclosure relates to a substrate processing method, a method of manufacturing a semiconductor device, a substrate processing apparatus and a program.

**[Related Art]**

As a part of a manufacturing process of a semiconductor device, a process of forming a film on a substrate accommodated in a process chamber may be performed (for example, see Patent Document 1).

**[Related Art Document]**

**[Patent Document]**

Patent Document 1: International Publication No. 2023/073924.

**[Disclosure]**

**[Technical Problem]**

However, it may be difficult to selectively form a metal-containing film starting from a specific region on the substrate.

According to the present disclosure, there is provided a technique capable of selectively forming a metal-containing film starting from a specific region on a substrate.

**[Technical Solution]**

According to an embodiment of the present disclosure, there is provided a technique that includes: (a) forming an adsorption promoting layer capable of promoting an adsorption of an organic-containing agent on a substrate by supplying a halogen-containing agent to the substrate; (b) forming a modification layer on the substrate by supplying the organic-containing agent to the substrate; (c) supplying a source material containing a metal element to the substrate; (d) supplying a reactant to the substrate; and (e) forming a metal-containing film in a region of the substrate where the modification layer is not formed, by performing (b), (c) and (d) N times after (a).

**[Advantageous Effects]**

According to some embodiments of the present disclosure, it is possible to selectively form a metal-containing film starting from a specific region on a substrate.

**[Brief Description of Drawings]**

FIG. 1 is a diagram schematically illustrating a vertical cross-section of a vertical type process furnace of a substrate processing apparatus according to one or more embodiments of the present disclosure.
FIG. 2 is a block diagram schematically illustrating a configuration of a controller and related components of the substrate processing apparatus according to the embodiments of the present disclosure.
FIG. 3 is a flow chart schematically illustrating a substrate processing according to the embodiments of the present disclosure.
FIG. 4 is a diagram schematically illustrating a cross-section of a substrate in a state where a metal-containing film is formed in a recess (concave portion) of the substrate.

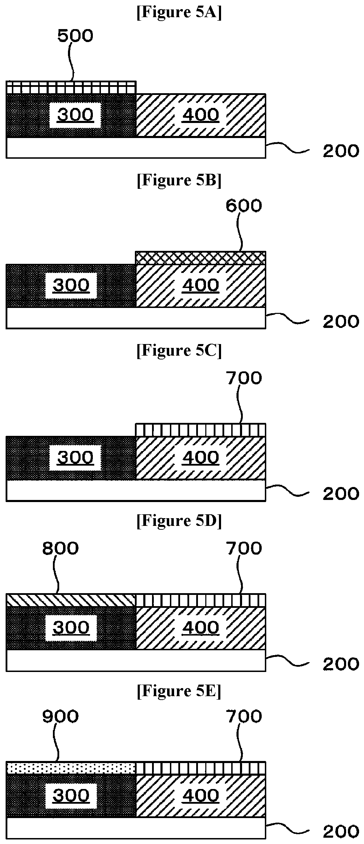

FIG. 5A is a diagram schematically illustrating a cross-section of the substrate in a state where a metal oxide film 500 is formed on a first film 300 of the substrate, FIG. 5B is a diagram schematically illustrating a cross-section of the substrate in a state where the metal oxide film 500 on the first film 300 of the substrate is removed and an adsorption promoting layer 600 is formed on a second film 400 of the substrate; FIG. 5C is a diagram schematically illustrating a cross-section of the substrate in a state where the adsorption promoting layer 600 on the second film 400 of the substrate is modified into a modification layer 700, FIG. 5D is a diagram schematically illustrating a cross-section of the substrate in a state where a metal-containing layer 800 is adsorbed on the first film 300 of the substrate, and FIG. 5E is a diagram schematically illustrating a cross-section of the substrate in a state where a metal-containing film 900 is formed on the first film 300 of the substrate.

FIG. 6 is a diagram schematically illustrating a modified example of the substrate processing according to the embodiments of the present disclosure.

FIG. 7 is a diagram schematically illustrating another modified example of the substrate processing according to the embodiments of the present disclosure.

## [Detailed Description]

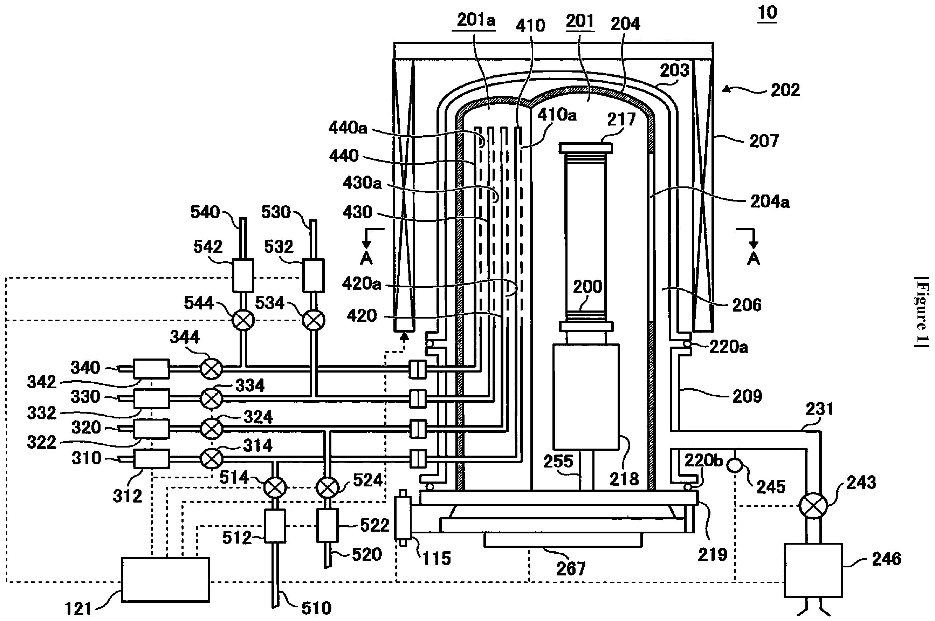

Hereinafter, one or more embodiments (also simply referred to as "embodiments") according to the technique of the present disclosure will be described mainly with reference to FIGS. 1 to 7. Further, the drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match. In addition, the same or similar reference numerals represent the same or similar components in the drawings. Thus, each component is described with reference to the drawing in which it first appears, and redundant descriptions related thereto will be omitted unless particularly necessary. In addition, the technique of the present disclosure is not limited to the embodiments described below. That is, the technique of the present disclosure may be modified in various ways without departing from the scope thereof.

(1) Configuration of Substrate Processing Apparatus

A substrate processing apparatus 10 according to the present embodiments includes a process furnace 202 provided with a heater 207 serving as a heating structure (heating system). The heater 207 is of a cylindrical shape, and is vertically installed while being supported by a support plate (not shown).

**An** outer tube 203 constituting a reaction vessel (process vessel) is provided in an inner side of the heater 207 to be aligned in a manner concentric with the heater 207. The outer tube 203 may also be referred to as an outer reaction tube. For example, the outer tube 203 is made of a heat resistant material such as quartz and silicon carbide. The outer tube 203 is of a cylindrical shape with a closed upper end and an open lower end. A manifold 209 is provided under the outer tube 203 to be aligned in a manner concentric with the outer tube 203. Hereinafter, the manifold 209 may also be referred to as an "MF 209". For example, the MF 209 is made of a metal such as stainless steel (SUS). The MF 209 is of a cylindrical shape with open upper and lower ends. An O-ring 220a serving as a seal is provided between the upper end of the MF 209 and the outer tube 203. Similar to the heater 207, the outer tube 203 is installed vertically.

An inner tube 204 constituting the reaction vessel is provided in an inner side of the outer tube 203. The inner tube 204 may also be referred to as an inner reaction tube. For example, the inner tube 204 is made of a heat resistant material such as quartz and silicon carbide. The inner tube 204 is of a cylindrical shape with a closed upper end and an open lower end. The process vessel (reaction vessel) is constituted mainly by the outer tube 203, the inner tube 204 and the MF 209. A process chamber 201 is provided in a hollow cylindrical portion of the process vessel (that is, an inside of the inner tube 204).

The process chamber 201 is configured to be capable of accommodating a plurality of wafers including a wafer 200 serving as a substrate in a horizontal orientation to be vertically arranged in a multistage manner by a boat 217 described later. Hereinafter, the plurality of wafers including the wafer 200 may also be simply referred to as "wafers 200".

Nozzles 410, 420, 430 and 440 are installed in the process chamber 201 so as to penetrate a side wall of the MF 209 and the inner tube 204. Gas supply pipes 310, 320, 330 and 340 are connected to the nozzles 410, 420, 430 and 440, respectively. However, the process furnace 202 of the present embodiments is not limited to the example mentioned above.

Mass flow controllers (MFCs) 312, 322, 332 and 342 serving as flow rate controllers (flow rate control structures) and valves 314, 324, 334 and 344 serving as opening/closing valves are sequentially installed at the gas supply pipes 310, 320, 330 and 340 in this order from upstream sides to downstream sides of the gas supply pipes 310, 320, 330 and 340 in a gas flow direction, respectively. **In** addition, gas supply pipes 510, 520, 530 and 540 through which an inert gas is supplied are connected to the gas supply pipes 310, 320, 330 and 340 at downstream sides of the valves 314, 324, 334 and 344 in the gas flow direction, respectively. MFCs 512, 522, 532 and 542 and valves 514, 524, 534 and 544 are sequentially installed at the gas supply pipes 510, 520, 530 and 540 in this order from upstream sides to downstream sides of the gas supply pipes 510, 520, 530 and 540 in the gas flow direction, respectively.

The nozzles 410, 420, 430 and 440 are connected to front ends (tips) of the gas supply pipes 310, 320, 330 and 340, respectively. Each of the nozzles 410, 420, 430 and 440 may be configured as an L-shaped nozzle. Horizontal portions of the nozzles 410, 420, 430 and 440 are installed so as to penetrate the side wall of the MF 209 and the inner tube 204. Vertical portions of the nozzles 410, 420, 430 and 440 are installed in a preliminary chamber 201a of a channel shape (a groove shape) protruding outward in a radial direction of the inner tube 204 and extending in a vertical direction. That is, the vertical portions of the nozzles 410, 420, 430 and 440 are installed in the preliminary chamber 201a to extend toward the upper end of the inner tube 204 (in a direction in which the wafers 200 are arranged) and along an inner wall of the inner tube 204.

The nozzles 410, 420, 430 and 440 extend from a lower region of the process chamber 201 to an upper region of the process chamber 201. The nozzles 410, 420, 430 and 440 are provided with a plurality of gas supply holes 410a, a plurality of gas supply holes 420a, a plurality of gas supply holes 430a and a plurality of gas supply holes 440a at positions facing the wafers 200, respectively.

A source gas (which is a source material containing a metal element) serving as one of process gases is supplied into the process chamber 201 through the gas supply pipe 310 provided with the MFC 312 and the valve 314 and the nozzle 410.

A reactive gas (which is a reactant of the source material) serving as one of the process gases is supplied into the process chamber 201 through the gas supply pipe 320 provided with the MFC 322 and the valve 324 and the nozzle 420.

An organic-containing gas (which is an organic-containing agent containing silicon (Si), an amino group and an alkyl group) serving as one of the process gases is supplied into the process chamber 201 through the gas supply pipe 330 provided with the MFC 332 and the valve 334 and the nozzle 430.

A halogen-containing gas (which is a halogen-containing agent containing a halogen element) serving as one of the process gases is supplied into the process chamber 201 through the gas supply pipe 340 provided with the MFC 342 and the valve 344 and the nozzle 440. Hereinafter, each of the process gases may also be referred to as a "process gas".

The inert gas is supplied into the process chamber 201 through the gas supply pipes 510, 520, 530 and 540 provided with the MFCs 512, 522, 532 and 542 and the valves 514, 524, 534 and 544, respectively, and the nozzles 410, 420, 430 and 440.

For example, in the present specification, the term "agent" may contain at least one selected from the group of a gaseous substance and a liquid substance. Further, the liquid substance may contain a mist substance. That is, each of the halogen-containing agent and the organic-containing agent may contain a gaseous substance, may contain a liquid substance such as a mist substance, or may contain both of the gaseous substance and the liquid substance.

A process gas supplier (which is a process gas supply structure or a process gas supply system) is constituted mainly by the gas supply pipes 310, 320, 330 and 340, the MFCs 312, 322, 332 and 342, the valves 314, 324, 334 and 344, and the nozzles 410, 420, 430 and 440. However, the process gas supplier may be constituted by the nozzles 410, 420, 430 and 440 without including other components mentioned above. The process gas supplier may also be simply referred to as a "gas supplier" which is a gas supply structure or a gas supply system. A first supplier (which is a first supply structure or a first supply system) is constituted mainly by the gas supply pipe 310, the MFC 312 and the valve 314. The first supplier may also be referred to as a "source material supplier" (which is a source material supply structure or a source material supply system) or a "source gas supplier" (which is a source gas supply structure or a source gas supply system). The first supplier may further include the nozzle 410. A second supplier (which is a second supply structure or a second supply system) is constituted mainly by the gas supply pipe 320, the MFC 322 and the valve 324. The second supplier may also be referred to as a "reactant supplier" (which is a reactant supply structure or a reactant supply system) or a "reactive gas supplier" (which is a reactive gas supply structure or a reactive gas supply system). The second supplier may further include the nozzle 420. A third supplier (which is a third supply structure or a third supply system) is constituted mainly by the gas supply pipe 330, the MFC 332 and the valve 334. The third supplier may also be referred to as an "organic-containing agent supplier" (which is an organic-containing agent supply structure or an organic-containing agent supply system) or an "organic-containing gas supplier" (which is an organic-containing gas supply structure or an organic-containing gas supply system). The third supplier may further include the nozzle 430. A fourth supplier (which is a fourth supply structure or a fourth supply system) is constituted mainly by the gas supply pipe 340, the MFC 342 and the valve 344. The fourth supplier may also be referred to as a "halogen-containing agent supplier" (which is a halogen-containing agent supply structure or a halogen-containing agent supply system) or a "halogen-containing gas supplier" (which is a halogen-containing gas supply structure or a halogen-containing gas supply system). The fourth supplier may further include the nozzle 440. An inert gas supplier (which is an inert gas supply structure or an inert gas supply system) is constituted mainly by the gas supply pipes 510, 520, 530 and 540, the MFCs 512, 522, 532 and 542 and the valves 514, 524, 534 and 544.

An exhaust hole 204a is provided to face the wafers 200. A gas supplied to the vicinity of the wafers 200 in the process chamber 201 through the gas supply holes 410a, the gas supply holes 420a, the gas supply holes 430a or the gas supply holes 440a flows in a horizontal direction. The gas that has flowed in the horizontal direction is exhausted through the exhaust hole 204a into an exhaust path 206. The exhaust hole 204a is not limited to a slit-shaped through-hole. For example, the exhaust hole 204a may be configured as a plurality of holes.

An exhaust pipe 231 through which an atmosphere (inner atmosphere) of the process chamber 201 is exhausted is installed at the MF 209. A pressure sensor 245 serving as a pressure detector (pressure detecting structure) configured to detect a pressure (inner pressure) of the process chamber 201, an APC (Automatic Pressure Controller) valve 243 and a vacuum pump 246 serving as a vacuum exhaust apparatus are sequentially connected to the exhaust pipe 231 in this order from an upstream side to a downstream side of the exhaust pipe 231 in the gas flow direction. Hereinafter, the vacuum pump 246 may also be simply referred to as a "pump 246". With the pump 246 in operation, the APC valve 243 may be opened or closed to perform a vacuum exhaust of the process chamber 201 or stop the vacuum exhaust. In addition, with the pump 246 in operation, an opening degree of the APC valve 243 may be adjusted in order to adjust the inner pressure of the process chamber 201. An exhauster (which is an exhaust structure or an exhaust system) is constituted mainly by the exhaust hole 204a, the exhaust path 206, the exhaust pipe 231, the APC valve 243 and the pressure sensor 245. The exhauster may further include the pump 246.

A seal cap 219 serving as a furnace opening lid capable of airtightly sealing (closing) a lower end opening of the MF 209 is provided under the MF 209. Hereinafter, the seal cap 219 may also be simply referred to as a "cap 219". The cap 219 is in contact with the lower end of the MF 209 from thereunder. For example, the cap 219 is made of a metal such as SUS, and is of a disk shape. An O-ring 220b serving as a seal is provided on an upper surface of the cap 219 so as to be in contact with the lower end of the MF 209. A rotator (which is a rotating structure) 267 configured to rotate the boat 217 accommodating the wafers 200 is provided at the cap 219 in a manner opposite to the process chamber 201. A rotating shaft 255 of the rotator 267 is connected to the boat 217 through the cap 219. As the rotator 267 rotates the boat 217, the wafers 200 are rotated. The cap 219 may be elevated or lowered in the vertical direction by a boat elevator 115 serving as an elevating structure vertically provided outside the outer tube 203. Hereinafter, the boat elevator 115 may also be simply referred to as an "elevator 115". When the cap 219 is elevated or lowered in the vertical direction by the elevator 115, the boat 217 may be transferred (loaded) into the process chamber 201 or transferred (unloaded) out of the process chamber 201. The elevator 115 serves as a transfer device (which is a transfer structure or a transfer system) that loads the boat 217 and the wafers 200 accommodated in the boat 217 into the process chamber 201 or unloads the boat 217 and the wafers 200 accommodated in the boat 217 out of the process chamber 201.

The boat 217 serving as a substrate support (substrate retainer) is configured to accommodate (or support) the wafers 200 (for example, 25 to 200 wafers) while the wafers 200 are horizontally oriented with their centers aligned with one another with a predetermined interval therebetween in the vertical direction. For example, the boat 217 is made of a heat resistant material such as quartz and silicon carbide. A heat insulating cylinder 218 (which is configured as a cylinder made of a heat resistant material such as quartz and silicon carbide) is provided under the boat 217 to support the boat 217. With such a configuration, the heat insulating cylinder 218 suppress the transmission of the heat from the heater 207 to the cap 219. However, the present embodiments are not limited thereto. For example, instead of the heat insulating cylinder 218, a plurality of heat insulating plates (not shown) (which are made of a heat resistant material such as quartz and silicon carbide and horizontally oriented) may be placed under the boat 217 in a multistage manner to support the boat 217.

A temperature sensor 263 serving as a temperature detector is installed in the inner tube 204. An amount of the electric current supplied (or applied) to the heater 207 is adjusted based on temperature information detected by the temperature sensor 263 such that a desired temperature distribution of a temperature (inner temperature) of the process chamber 201 can be obtained. The temperature sensor 263 is provided along the inner wall of the inner tube 204.

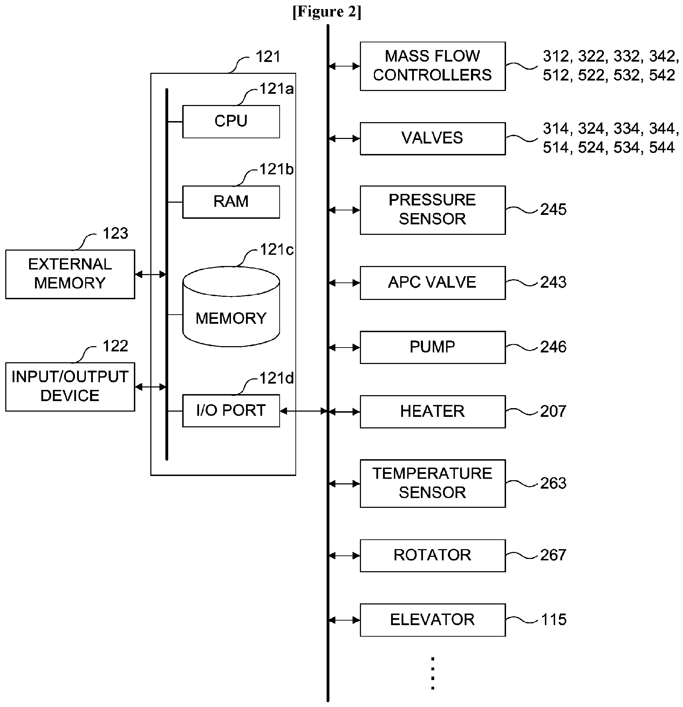

As shown in FIG. 2, a controller 121 serving as a control structure (or a control apparatus) is constituted by a computer including a CPU (Central Processing Unit) 121a, a RAM (Random Access Memory) 121b, a memory 121c and an I/O port 121d. The RAM 121b, the memory 121c and the I/O port 121d are configured to exchange data with the CPU 121a through an internal bus (not shown). For example, an input/output device 122 constituted by a component such as a touch panel is connected to the controller 121. In addition, the controller 121 is configured such that an external memory 123 can be connected to the controller 121.

The memory 121c is configured by a component such as a flash memory and a hard disk drive (HDD). For example, a control program configured to control an operation of the substrate processing apparatus 10 or a process recipe containing information on procedures and conditions of a method of manufacturing a semiconductor device (substrate processing method) described later is readably stored in the memory 121c. The process recipe is obtained by combining steps (procedures) of the method of manufacturing the semiconductor device (substrate processing method) described later such that the controller 121 can execute the steps to acquire a predetermined result, and functions as a program. Hereafter, the process recipe and the control program may be collectively or individually referred to as a "program". Thus, in the present specification, the term "program" may refer to the process recipe alone, may refer to the control program alone, or may refer to a combination of the process recipe and the control program. The RAM 121b functions as a memory area (work area) where a program or data read by the CPU 121a is temporarily stored.

The I/O port 121d is connected to the components described above such as the MFCs 312, 322, 332, 342, 512, 522, 532 and 542, the valves 314, 324, 334, 344, 514, 524, 534 and 544, the pressure sensor 245, the APC valve 243, the pump 246, the heater 207, the temperature sensor 263, the rotator 267 and the elevator 115.

The CPU 121a is configured to read the control program from the memory 121c and execute the read control program. In addition, the CPU 121a is configured to read a recipe such as the process recipe from the memory 121c in accordance with an operation command inputted from the input/output device 122. In accordance with the contents of the read recipe, the CPU 121a may be configured to control various operations such as flow rate adjusting operations for various gases by the MFCs 312, 322, 332, 342, 512, 522, 532 and 542, opening and closing operations of the valves 314, 324, 334, 344, 514, 524, 534 and 544, an opening and closing operation of the APC valve 243, a pressure adjusting operation by the APC valve 243 based on the pressure sensor 245, a temperature adjusting operation by the heater 207 based on the temperature sensor 263, a start and stop of the pump 246, an operation of adjusting a rotation and a rotation speed of the boat 217 by the rotator 267, an elevating and lowering operation of the boat 217 by the elevator 115 and an operation of transferring and accommodating the wafer 200 into the boat 217.

The controller 121 may be embodied by installing the above-mentioned program stored in the external memory 123 into the computer. For example, the external memory 123 may include a magnetic tape, a magnetic disk such as a flexible disk and a hard disk, an optical disk such as a CD and a DVD, a magneto-optical disk such as an MO and a semiconductor memory such as a USB memory and a memory card. The memory 121c or the external memory 123 may be embodied by a non-transitory computer readable recording medium. Hereafter, the memory 121c and the external memory 123 may be collectively or individually referred to as a "recording medium". Thus, in the present specification, the term "recording medium" may refer to the memory 121c alone, may refer to the external memory 123 alone, and may refer to both of the memory 121c and the external memory 123. Instead of the external memory 123, a communication structure such as the Internet and a dedicated line may be used for providing the program to the computer.

(2) Substrate Processing

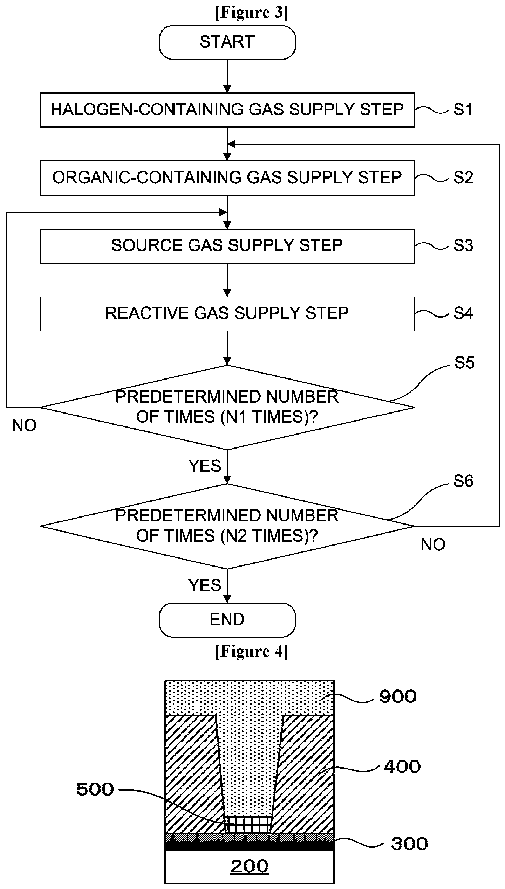

Hereinafter, as a part of a manufacturing process of the semiconductor device, an example of a substrate processing such as a film forming step of selectively forming a metal-containing film 900 containing a metal element on a first film 300 of the wafer 200 (wherein the first film 300 and a second film 400 are formed on a surface of the wafer 200) will be described with reference to FIGS. 3 to 5. The substrate processing (that is, the film forming step) is performed using the process furnace 202 of the substrate processing apparatus 10 mentioned above. In the following description, operations of the components constituting the substrate processing apparatus 10 are controlled by the controller 121.

The first film 300 is a metal-containing film. As the metal-containing film, for example, a film containing the metal element serving as a transition metal (also referred to as a "transition element") may be used. For example, the metal-containing film may contain one or more transition elements such as tungsten (W), molybdenum (Mo), copper (Cu) and cobalt (Co). The first film 300 may be used as a metal wiring. For example, the first film 300 may be used as a metal wiring M1 in a lowermost layer of a wiring layer, or may be used as a metal wiring My in an intermediate layer (y is a natural number).

The second film 400 is a non-metal oxide film. As the non-metal oxide film, for example, an insulating film such as a silicon oxide film ($SiO_2$ film) may be used.

According to the present embodiments, for example, as shown in FIG. 4, the first film 300 serving as the metal-containing film is formed on the wafer 200, and the second film 400 serving as the insulating film is formed on the first film 300. In addition, a recess (concave portion) such as a trench and a hole is formed in the second film 400, and the metal-containing film 900 such as a ruthenium (Ru) film may be formed in the recess. Before the metal-containing film 900 is formed in the recess, a metal oxide film 500 serving as a natural oxide film may be formed on a surface of the first film 300. In particular, when the first film 300 contains the transition metal such as tungsten, molybdenum, copper and cobalt, the first film 300 can be easily oxidized. As shown in FIG. 4, when the metal-containing film 900 is formed in the recess where the metal oxide film 500 remains without being removed, a contact resistance of the metal-containing film 900 may increase. In addition, when the ruthenium film is formed as the metal-containing film 900, for example, it is preferable to reduce the contact resistance in order to utilize a low resistance characteristic of the ruthenium film. In addition, when the ruthenium film is formed, the ruthenium film is less likely to grow on the metal oxide film 500.

In the substrate processing (that is, the method of manufacturing the semiconductor device) according to the present embodiments, with respect to the wafer 200 including the first film 300 (on which the metal oxide film 500 is formed) and the second film 400, the metal-containing film 900 is selectively formed on the first film 300 while removing at least a part of the metal oxide film 500 formed on the first film 300. As a result, by promoting a growth of the metal-containing film 900 formed in the recess of the wafer 200, it is possible to reduce the contact resistance of the metal-containing film 900.

FIGS. 5A to 5E are diagrams schematically illustrating cross-sections of the wafer 200 as shown in FIG. 4 including the first film 300 and the second film 400, respectively. As shown in FIG. 5A, the metal oxide film 500 serving as the natural oxide film is formed on the first film 300.

In the present specification, the substrate processing shown in FIG. 3 may be illustrated as follows for convenience. Substrate processings of modified examples described later will be also represented in the same manner.

Halogen-containing gas → [Organic-containing gas → (Source gas → Reactive gas) × N1] × N2

N1 and N2 are integers of 1 or more.

That is, when N1 = 1, it may be illustrated as follows. The same also applies below.

$$\text{Halogen-containing gas} \rightarrow (\text{Organic-containing gas} \rightarrow \text{Source gas} \rightarrow \text{Reactive gas}) \times \text{N2}$$

**In** the present specification, the term "wafer" may refer to "a wafer itself", or may refer to "a wafer and a stacked structure (aggregated structure) of a predetermined layer (or layers) or a film (or films) formed on a surface of the wafer". **In** the present specification, the term "a surface of a wafer" may refer to "a surface of a wafer itself", or may refer to "a surface of a predetermined layer (or a predetermined film) formed on a wafer". Thus, in the present specification, "forming a predetermined layer (or a film) on a wafer" may refer to "forming a predetermined layer (or a film) directly on a surface of a wafer itself", or may refer to "forming a predetermined layer (or a film) on a surface of another layer (or another film) formed on a wafer". In the present specification, the terms "substrate" and "wafer" may be used as substantially the same meaning.

<Wafer Charging Step and Boat Loading Step>

The wafers 200 are charged (transferred) into the boat 217. After the boat 217 is charged with the wafers 200, as shown in FIG. 1, the boat 217 supporting the wafers 200 is elevated by the elevator 115 and loaded (transferred) into the process chamber 201, and accommodated in the process vessel. With the boat 217 accommodated in the process vessel, the cap 219 seals a lower end opening of the outer tube 203 via the O-ring 220b.

<Pressure Adjusting Step and Temperature Adjusting Step>

Then, the pump 246 vacuum-exhausts the inner atmosphere of the process chamber 201 (that is, a space in which the wafers 200 are present (accommodated)) such that the inner pressure of the process chamber 201 reaches and is maintained at a desired pressure. When the pump 246 vacuum-exhausts the inner atmosphere of the process chamber 201, the inner pressure of the process chamber 201 is measured by the pressure sensor 245, and the APC valve 243 is feedback-controlled based on pressure information detected by the pressure sensor 245 (pressure adjusting step). The pump 246 continuously vacuum-exhausts the inner atmosphere of the process chamber 201 until at least a processing of the wafer 200 is completed.

In addition, the heater 207 heats the process chamber 201 such that the inner temperature of the process chamber 201 reaches and is maintained at a desired temperature. When the heater 207 heats the process chamber 201, an amount of the electric current supplied to the heater 207 is feedback-controlled based on the temperature information detected by the temperature sensor 263 such that the desired temperature distribution of the inner temperature of the process chamber 201 can be obtained (temperature adjusting step). The heater 207 continuously heats the process chamber 201 until at least the processing of the wafer 200 is completed.

A. First Pre-treatment Step

As a first pre-treatment step, a halogen-containing gas supply step (step S1) is performed.

<Halogen-containing Gas Supply Step, Step S1>

In the present step, the valve 344 is opened to supply the halogen-containing gas into the gas supply pipe 340. After a flow rate of the halogen-containing gas is adjusted by the MFC 342, the halogen-containing gas whose flow rate is adjusted is supplied into the process chamber 201 through the gas supply holes 440a of the nozzle 440, and is exhausted through the exhaust pipe 231. Thereby, the halogen-containing gas is supplied onto the wafer 200. In the present step, in parallel with a supply of the halogen-containing gas, the valve 544 is opened to supply the inert gas into the gas supply pipe 540. After a flow rate of the inert gas supplied into the gas supply pipe 540 is adjusted by the MFC 542, the inert gas whose flow rate is adjusted is supplied into the process chamber 201 together with the halogen-containing gas, and is exhausted through the exhaust pipe 231. In addition, in order to prevent the halogen-containing gas from entering the nozzles 410, 420 and 430, the valves 514, 524 and 534 are opened to supply the inert gas into the gas supply pipes 510, 520 and 530. Then the inert gas is supplied into the process chamber 201 through the gas supply pipes 310, 320 and 330 and the nozzles 410, 420 and 430, and is exhausted through the exhaust pipe 231.

In the present step, for example, the APC valve 243 is appropriately adjusted such that the inner pressure of the process chamber 201 can be set to a pressure within a range from 1 Pa to 3,990 Pa. For example, a supply flow rate of the halogen-containing gas controlled by the MFC 342 can be set to a flow rate within a range from 0.05 slm to 20 slm. For example, each supply flow rate of the inert gas controlled by each of the MFCs 512, 522, 532 and 542 can be set to a flow rate within a range from 0.1 slm to 50 slm. In the present specification, a notation of a numerical range such as "from 1 Pa to 3,990 Pa" means that a lower limit and an upper limit thereof are included in the numerical range. Therefore, for example, the numerical range "from 1 Pa to 3,990 Pa" means a range equal to or higher than 1 Pa and equal to or lower than 3,990 Pa. The same also applies to other numerical ranges described herein.

A substitution reaction occurs between the halogen-containing gas and at least a part of the metal oxide film 500 formed on the first film 300. That is, as shown in FIGS. 5A and 5B, an oxygen atom (O) in the metal oxide film 500 reacts with the halogen element contained in the halogen-containing gas so as to be desorbed from the metal oxide film 500, and is discharged (exhausted) from the process chamber 201 as reaction by-products. As a result, at least a part of the metal oxide film 500 is removed (etched). In addition, in the present step, the halogen element contained in the halogen-containing gas is adsorbed onto the second film 400. Thereby, it is possible to form an adsorption promoting layer 600 serving as a layer capable of promoting an adsorption of the organic-containing gas in a subsequent step, that is, an organic-containing gas supply step (step S2).

As the halogen-containing gas, for example, a gas capable of selectively etching the metal oxide film 500 and capable of adsorbing the halogen element onto the non-metal oxide film may be used. As the halogen-containing gas, for example, a chlorine-containing gas containing chlorine (Cl) may be used. As the chlorine-containing gas, for example, a gas containing one or more chlorine atoms and one or more oxygen atoms may be used. That is, as the chlorine-containing gas, for example, an oxyhalide whose molecular structure is $MO_xCl_y$ may be used. In the formula shown above, for example, M may contain one or more elements among phosphorus (P), silicon (Si), germanium (Ge), sulfur (S) and carbon (C), which are a Group 14 element, a Group 15 element or a Group 16 element. As the oxyhalide, for example, a gas (such as $POCl_3$, $SOCl_2$ and $COCl_2$ gas) containing one or more elements among the Group 14 element, the Group 15 element and the Group 16 element and further containing oxygen and chlorine may be used. As the halogen-containing gas, for example, one or more of the substances exemplified above may be used.

As the inert gas, for example, nitrogen ($N_2$) gas or a rare gas such as argon (Ar) gas, helium (He) gas, neon (Ne) gas and xenon (Xe) gas may be used. As the inert gas, one or more of the substances exemplified above may be used. The same also applies to other inert gases supplied in each step described later.

Specifically, for example, by supplying the oxyhalide (which is an example of the halogen-containing gas) to the wafer 200 including a tungsten (W) film (which is an example of the first film 300) and the $SiO_2$ film (which is an example of the second film 400), oxygen (O) contained in a tungsten oxide film ($WO_x$ film) (which serves as the metal oxide film formed on a surface of the tungsten film) reacts with chlorine and oxygen contained in the oxyhalide to generate WOCl (which is to be desorbed from the $WO_x$ film). As a result, the $WO_x$ film is etched. In addition, chlorine desorbed from the oxyhalide is adsorbed onto the $SiO_2$ film. In other words, a chlorine termination is formed on the $SiO_2$ film, and thereby, a chlorine layer (which is an example of the adsorption promoting layer 600 and an adsorption layer of chlorine) is formed.

That is, by supplying the halogen-containing gas to the wafer 200, the adsorption promoting layer 600 capable of promoting the adsorption of the organic-containing gas described later is formed on the second film 400 while the metal oxide film 500 formed on the first film 300 is etched. The halogen-containing gas may be referred to as an "etching gas" capable of etching the metal oxide film 500, or as an "adsorption promoting gas" capable of promoting the adsorption of the organic-containing gas on the second film 400.

After a predetermined time has elapsed from the supply of the halogen-containing gas, the valve 344 of the gas supply pipe 340 is closed to stop the supply of the halogen-containing gas. In the present step, with the APC valve 243 of the exhaust pipe 231 open, the pump 246 vacuum-exhausts the inner atmosphere of the process chamber 201 to remove a substance (which remains in the process chamber 201) from the process chamber 201. Thereby, it is possible to remove the substance such as the halogen-containing gas (which remains unreacted or which contributed to an etching of the metal oxide film 500 or contributed to a formation of the adsorption promoting layer 600 on the second film 400) from the process chamber 201. That is, the space in which the wafers 200 are present is exhausted. In other words, the process chamber 201 is purged. In the present step, with the valves 514, 524, 534 and 544 open, the inert gas is continuously supplied into the process chamber 201.

B. Second Pre-treatment Step

As a second pre-treatment step, the organic-containing gas supply step (step S2) is performed.

<Organic-containing Gas Supply Step, Step S2>

In the present step, the valve 334 is opened to supply the organic-containing gas into the gas supply pipe 330. After a flow rate of the organic-containing gas is adjusted by the MFC 332, the organic-containing gas whose flow rate is adjusted is supplied into the process chamber 201 through the gas supply holes 430a of the nozzle 430, and is exhausted through the exhaust pipe 231. Thereby, the organic-containing gas is supplied onto the wafer 200. In the present step, in parallel with a supply of the organic-containing gas, the valve 534 is opened to supply the inert gas into the gas supply pipe 530. After a flow rate of the inert gas supplied into the gas supply pipe 530 is adjusted by the MFC 532, the inert gas whose flow rate is adjusted is supplied into the process chamber 201 together with the organic-containing gas, and is exhausted through the exhaust pipe 231. In addition, in order to prevent the organic-containing gas from entering the nozzles 410, 420 and 440, the valves 514, 524 and 544 are opened to supply the inert gas into the gas supply pipes 510, 520 and 540. Then the inert gas is supplied into the process chamber 201 through the gas supply pipes 310, 320 and 340 and the nozzles 410, 420 and 440, and is exhausted through the exhaust pipe 231.

In the present step, for example, the APC valve 243 is appropriately adjusted such that the inner pressure of the process chamber 201 can be set to a pressure within a range from 1 Pa to 2,000 Pa. For example, a supply flow rate of the organic-containing gas controlled by the MFC 332 can be set to a flow rate within a range from 0.001 slm to 3 slm. For example, each supply flow rate of the inert gas controlled by each of the MFCs 512, 522, 532 and 542 can be set to a flow rate within a range from 0.1 slm to 20 slm.

The organic-containing gas is a gas preferentially (also referred to as "positively") adsorbed to the adsorption promoting layer 600 on the second film 400 rather than to the first film 300. Therefore, as shown in FIGS. 5B and 5C, by supplying the organic-containing gas, at least a part of a substance such as $Si(CH_3)_3$ contained in the organic-containing gas is adsorbed to the halogen element (for example, the chlorine termination) contained in the adsorption promoting layer 600 on the second film 400. As a result, the adsorption promoting layer 600 on the second film 400 is modified into a modification layer (which is a modified layer) 700. In addition, the halogen element (for example, the chlorine termination) contained in the adsorption promoting layer 600 on the second film 400 is substituted (or replaced) by at least a part of the substance such as the $Si(CH_3)_3$ contained in the organic-containing gas. As a result, the adsorption promoting layer 600 on the second film 400 is modified into the modification layer 700. In other words, by supplying the organic-containing gas, the adsorption promoting layer 600 on the second film 400 is modified into the modification layer 700, and a silicon alkyl termination is formed in the modification layer 700.

That is, for example, the $Si(CH_3)_3$ contained in the organic-containing gas is not adsorbed onto the first film 300, but is adsorbed to or substituted by the halogen element adsorbed to the adsorption promoting layer 600 on the second film 400. Then, the adsorption promoting layer 600 on the second film 400 is modified into the modification layer 700 containing the silicon alkyl termination. The modification layer 700 may also be referred to as an "inhibitor layer" capable of inhibiting a formation of the metal-containing film 900 in a subsequent step, that is, a film forming step.

As the organic-containing gas, for example, a gas containing one or more amino groups and an alkyl group, preferably, a gas of a material containing organosilicon may be used. As the organic-containing gas, for example, an aminosilane-containing gas (which is aminosilane-based) may be used. More preferably, a silylamine-containing gas (which is silyl-based and silylamine-based) may be used. The silyl-based gas is a material containing a $-SiR_x$ group. In the formula shown above, for example, R is the alkyl group or the amino group. For example, x is an integer of 1 or more. As such a material, for example, a gas such as $(CH_3)_2NSi(CH_3)_3$, $(C_2H_5)HNSi(CH_3)_3$, $(C_3H_7)_2HNSi(CH_3)_3$, $(C_4H_9)_2HNSi(CH_3)_3$, $(C_2H_5)_2NSi(CH_3)_3$, $(C_3H_7)_2NSi(CH_3)_3$, $(CH_3)_2NSiH(CH_3)_2$, $(C_2H_5)HNSiH(CH_3)_2$, $(C_2H_5)_2NSiH(CH_3)$, $(C_3H_7)_2NSIH(CH_3)_2$, $(CH_3)_2NSIH_2(CH_3)$, $(C_2H_5)HNSiH_2(CH_3)$, $(CH_3)_2NSiH(C_2H_3)_2$, $(C_2H_5)HNSiH(C_2H_5)_2$, $(C_2H_5)_2NSiH(C_2H_5)_2$, $(CH_3)_2NSiH_2(C_2H_3)$, $(C_2H_5)HNSiH_2(C_2H_5)$ and $(C_2H_5)_2NSiH_2(C_2H_5)$ may be used. As the organic-containing gas, for example, one or more of the substances exemplified above may be used. Preferably, as the organic-containing gas, for example, a gas containing two or more alkyl groups may be used. As the number of R (for example, the alkyl groups) bonded to silicon increases, the formation of the metal-containing film 900 may be effectively suppressed (inhibited).

Specifically, for example, when the silylamine-containing gas is supplied to the wafer 200 including the tungsten film and the $SiO_2$ film with chlorine adsorbed on a surface thereof, the silylamine-containing gas is not adsorbed onto the tungsten film, but is adsorbed to the chlorine termination on the $SiO_2$ film or is substituted by the chlorine termination on the $SiO_2$ film. That is, a layer such as an adsorption layer of a silicon alkyl group containing chlorine and an adsorption layer of the silicon alkyl group from which chlorine is desorbed may be formed on the $SiO_2$ film by at least a part of the silicon alkyl group and the like contained in the silylamine-containing gas. In other words, the chlorine layer on the $SiO_2$ film is modified into a silylamine layer. The silylamine layer may be a silylamine layer containing chlorine, may be a silylamine layer free of chlorine (that is, a silylamine layer without containing chlorine), or may be both of the silylamine layer containing chlorine and the silylamine layer free of chlorine.

That is, by supplying the organic-containing gas to the wafer 200 including the first film 300 and the adsorption promoting layer 600, the adsorption promoting layer 600 on the second film 400 on the wafer 200 is modified into the modification layer 700 serving as an inhibitor layer capable of inhibiting the formation of the metal-containing film 900 in a subsequent step, that is, the film forming step. The organic-containing gas may also be referred to as a "modifying gas" or a "modifying agent" capable of modifying the adsorption promoting layer 600.

After a predetermined time has elapsed from the supply of the organic-containing gas, the valve 334 of the gas supply pipe 330 is closed to stop the supply of the organic-containing gas. In the present step, with the APC valve 243 of the exhaust pipe 231 open, the pump 246 vacuum-exhausts the inner atmosphere of the process chamber 201 to remove a substance (which remains in the process chamber 201) from the process chamber 201. Thereby, it is possible to remove the substance such as the organic-containing gas (which remains unreacted or which contributed to a modification of the adsorption promoting layer 600) from the process chamber 201. That is, the space in which the wafers 200 are present is exhausted. **In** other words, the process chamber 201 is purged. In the present step, with the valves 514, 524, 534 and 544 open, the inert gas is continuously supplied into the process chamber 201.

For example, the halogen-containing gas supply step (that is, the step S1) and the organic-containing gas supply step (that is, the step S2) may be performed cyclically. Thereby, it is possible to improve an efficiency of discharging the reaction by-products.

C. Metal-containing Film Forming Step (Film Forming Step)

As the film forming step, the followings steps S3 to S5 are performed.

<Source Gas Supply Step, Step S3>

In the present step, the valve 314 is opened to supply the source gas into the gas supply pipe 310. After a flow rate of the source gas is adjusted by the MFC 312, the source gas whose flow rate is adjusted is supplied into the process chamber 201 through the gas supply holes 410a of the nozzle 410, and is exhausted through the exhaust pipe 231. Thereby, the source gas is supplied onto the wafer 200. In the present step, in parallel with a supply of the source gas, the valve 514 is opened to supply the inert gas into the gas supply pipe 510. After a flow rate of the inert gas supplied into the gas supply pipe 510 is adjusted by the MFC 512, the inert gas whose flow rate is adjusted is supplied into the process chamber 201 together with the source gas, and is exhausted through the exhaust pipe 231. In addition, in order to prevent the source gas from entering the nozzles 420, 430 and 440, the valves 524, 534 and 544 are opened to supply the inert gas into the gas supply pipes 520, 530 and 540. Then the inert gas is supplied into the process chamber 201 through the gas supply pipes 320, 330 and 340 and the nozzles 420, 430 and 440, and is exhausted through the exhaust pipe 231.

In the present step, for example, the APC valve 243 is appropriately adjusted such that the inner pressure of the process chamber 201 can be set to a pressure within a range from 1 Pa to 3,990 Pa. For example, a supply flow rate of the source gas controlled by the MFC 312 can be set to a flow rate within a range from 0.05 slm to 1 slm. For example, each supply flow rate of the inert gas controlled by each of the MFCs 512, 522, 532 and 542 can be set to a flow rate within a range from 0.1 slm to 50 slm.

In the present step, since the modification layer 700 containing the silicon alkyl termination is formed on the second film 400, at least a part of atoms and molecules contained in the source gas are less likely to be adsorbed on the modification layer 700 on the second film 400 than on the first film 300.

Therefore, as shown in FIGS. 5C and 5D, when the source gas is supplied to the wafer 200, at least a part of the atoms and the molecules contained in the source gas are adsorbed onto the first film 300 of the wafer 200. Thereby, a metal-containing layer 800 is formed. The metal-containing layer 800 may be a metal layer containing other elements, or may be an adsorption layer of the source gas. In addition, since the modification layer 700 is formed on the second film 400 of the wafer 200, the metal-containing layer 800 is less likely to be formed on the modification layer 700 on the second film 400.

As the source gas, for example, a metal-containing gas may be used. As the metal-containing gas, for example, a gas containing a metal element serving as the transition metal (transition element) may be used. Preferably, as the metal-containing gas, for example, a gas containing a platinum group element serving as a Group 8 element may be used. As the metal-containing gas, for example, a ruthenium-containing gas may be used. In a manner described above, by using the gas containing the transition metal (the platinum group element serving as the Group 8 element), it is possible to form a metal-containing film whose resistance is low. In addition, as the metal-containing gas, for example, a gas containing the metal element and a carbonyl group may be used. Thereby, it is possible to improve a film forming rate.

As the metal-containing gas, for example, a gas obtained by vaporizing an organometallic material such as $Ru(C_2H_3C_3H_4)_2$, $Ru(C_5H_5)(C4H_9C_5H_4)$, $Ru[CH_3COCHCO(CH_2)_3CH_3]_3$, $Ru(C_2H_5C_5H_4)((CH_3)C_5H_5)$, $Ru(C_7H_8)$ $(C_7H_1O_2)$, $C_{16}H_{22}O_6Ru$, $Ru_3(CO)_{12}$, $(DMBD)Ru(CO)_3$, $(BD)Ru(CO_3)$, $(CHD)Ru(CO)_3$, $C_{14}H_{10}O_4Ru_2$ and $(Ru(CO)_3Cl_2)_2$ may be used. As the metal-containing gas, for example, one or more of the substances exemplified above may be used.

Specifically, for example, when the ruthenium-containing gas is supplied as the source gas to the wafer 200 including the tungsten film and the $SiO_2$ film with the $Si(CH_3)_3$ adsorbed on the surface thereof and the silylamine layer formed thereon, a ruthenium-containing layer (ruthenium-containing film) is formed on the tungsten film. In addition, the ruthenium-containing gas is less likely to be adsorbed onto the $SiO_2$ film with the $Si(CH_3)_3$ adsorbed on the surface thereof and the silylamine layer formed thereon, and therefore the ruthenium-containing film is less likely to be formed. In other words, the ruthenium-containing film is selectively formed on the tungsten film on the wafer 200. Such a phenomenon may also be referred to as "the ruthenium-containing film is preferentially formed on the tungsten film on the wafer 200".

After a predetermined time has elapsed from the supply of the source gas, the valve 314 of the gas supply pipe 310 is closed to stop the supply of the source gas. For example, a time duration of supplying the source gas to the wafer 200 can be set to a time duration within a range from 1 second to 120 seconds. In the present step, with the APC valve 243 of the exhaust pipe 231 open, the pump 246 vacuum-exhausts the inner atmosphere of the process chamber 201 to remove a substance (which remains in the process chamber 201) from the process chamber 201. Thereby, it is possible to remove the substance such as the source gas (which remains unreacted or which contributed to a formation of the metal-containing layer 800) from the process chamber 201. That is, the space in which the wafers 200 are present is exhausted. In other words, the process chamber 201 is purged. In the present step, with the valves 514, 524, 534 and 544 open, the inert gas is continuously supplied into the process chamber 201.

<Reactive Gas Supply Step, Step S4>

After removing a residual gas (that is, the substance remains in the process chamber 201) from the process chamber 201, in the present step, the valve 324 is opened to supply the reactive gas into the gas supply pipe 320. After a flow rate of the reactive gas is adjusted by the MFC 322, the reactive gas whose flow rate is adjusted is supplied into the process chamber 201 through the gas supply holes 420a of the nozzle 420, and is exhausted through the exhaust pipe 231. Thereby, the reactive gas is supplied onto the wafer 200. In the present step, in parallel with a supply of the reactive gas, the valve 524 is opened to supply the inert gas into the gas supply pipe 520. After a flow rate of the inert gas supplied into the gas supply pipe 520 is adjusted by the MFC 522, the inert gas whose flow rate is adjusted is supplied into the process chamber 201 together with the reactive gas, and is exhausted through the exhaust pipe 231. In addition, in order to prevent the reactive gas from entering the nozzles 410, 430 and 440, the valves 514, 534 and 544 are opened to supply the inert gas into the gas supply pipes 510, 530 and 540. Then the inert gas is supplied into the process chamber 201 through the gas supply pipes 310, 330 and 340 and the nozzles 410, 430 and 440, and is exhausted through the exhaust pipe 231.
In the present step, for example, the APC valve 243 is appropriately adjusted such that the inner pressure of the process chamber 201 can be set to a pressure within a range from 5 Pa to 15,000 Pa. For example, a supply flow rate of the reactive gas controlled by the MFC 322 can be set to a flow rate within a range from 1 slm to 100 slm, preferably from 15 slm to 50 slm. For example, each supply flow rate of the inert gas controlled by each of the MFCs 512, 522, 532 and 542 can be set to a flow rate within a range from 0.1 slm to 50 slm.
The reactive gas reacts with the metal-containing layer 800 adsorbed on the first film 300 to form a metal-containing layer (which constitutes the metal-containing film 900) in which oxygen (oxygen concentration) is reduced as compared with the metal-containing layer 800. Hereinafter, the metal-containing layer constituting the metal-containing film 900 may also be referred to as a "metal-containing layer 900". In other words, by supplying the reactive gas to the wafer 200, the metal-containing layer 900 is formed on the first film 300 of the wafer 200. Since the modification layer 700 is formed on the second film 400, the metal-containing layer 900 is not formed on the second film 400 (that is, on the modification layer 700 on the second film 400).
As the reactive gas, for example, a gas such as a hydrogen-containing gas may be used. As the hydrogen-containing gas, for example, a gas such as $H_2$ gas, deuterium ($D_2$) gas and a gas containing activated hydrogen may be used. As the reactive gas, for example, one or more of the substances exemplified above may be used.
In the present embodiments, for example, when the $H_2$ gas is used as the reactive gas, a substitution reaction occurs between the $H_2$ gas and at least a part of the metal-containing layer 800 formed on the wafer 200 in the step S3. For example, when the gas containing the metal element and the carbonyl group is used as the source gas, a substance such as oxygen in the metal-containing layer 800 reacts with $H_2$ so as to be desorbed from the metal-containing layer 800, and is discharged (exhausted) from the process chamber 201 as reaction by-products such as water vapor ($H_2O$). Thereby, the metal-containing layer 900 (which contains the metal element) in which oxygen (oxygen concentration) is reduced is formed on the wafer 200.
After the metal-containing layer 900 is formed, the valve 324 is closed to stop the supply of the reactive gas. Then, by process procedures similar to those of the step S3 described above, a substance (which remains in the process chamber 201) is removed from the process chamber 201. Thereby, it is possible to remove the substance such as the reactive gas (which remains unreacted or which contributed to a formation of the metal-containing layer 900) and the reaction by-products from the process chamber 201. In other words, the process chamber 201 is purged.

<Performing Predetermined Number of Times, Step S5>

By performing a first cycle (in which the step S3 and the step S4 described above are sequentially performed in this order) a predetermined number of times (N1 times, N1 is an integer of 1 or more), the metal-containing layer 900 of a predetermined thickness is formed.

<Performing Predetermined Number of Times, Step S6>

Then, after performing the first cycle (in which the step S3 and the step S4 described above are sequentially performed in this order) the predetermined number of times (N1 times, N1 is an integer of 1 or more), the process returns to a process of the step S2 described above, and a second cycle (in which the step S2 to the step S5 described above are sequentially performed in this order) is performed a predetermined number of times (N2 times, N2 is an integer of 1 or more). That is. after the halogen-containing gas supply step (that is, the step S1), by performing the second cycle (in which the step S2 to the step S5 described above are sequentially performed in this order) the predetermined number of times (N2 times, N2 is an integer of 1 or more), the metal-containing film 900 of a predetermined thickness is formed on the first film 300 (which is a region where the modification layer 700 is not formed) of the wafer 200. It is preferable to perform the steps S2 to S4 in this order. Thereby, it is possible to form the metal-containing film 900 on the first film 300 while suppressing a desorption of the halogen element such as chlorine contained in the modification layer 700 on the second film 400.

That is, as shown in FIG. 5E, it is possible to selectively form the metal-containing film 900 of a predetermined thickness on the first film 300 (which is the region where the modification layer 700 is not formed) of the wafer 200 including the first film 300 and the second film 400 on the surface thereof. It is preferable that a cycle such as the first cycle and the second cycle described above is performed a plurality number of times. Thereby, it is possible to reduce an amount of the metal oxide film 500 on the surface of the first film 300, and it is also possible to selectively form the metal-containing film 900 on the first film 300. That is, it is possible to selectively form the metal-containing film 900 on the first film 300 in a state where the metal oxide film 500 on the first film 300 in the recess of the wafer 200 is removed.

Specifically, for example, by supplying the ruthenium-containing gas (which is an example of the source gas) and the $H_2$ gas (which is an example of the reactive gas) to the wafer 200 including the tungsten film and the $SiO_2$ film with the silylamine layer formed on the surface thereof, it is possible to selectively form the ruthenium-containing film on the tungsten film. In other words, it is possible to grow the ruthenium film on the tungsten film.

<After-purge Step and Returning to Atmospheric Pressure Step>

Then, the inert gas is supplied into the process chamber 201 through each of the gas supply pipes 510 to 540, and is exhausted through the exhaust pipe 231. The inert gas acts as a purge gas. Thereby, the inner atmosphere of the process chamber 201 is purged with the inert gas. As a result, the gas remaining in the process chamber 201 and the reaction by-product remaining in the process chamber 201 are removed from the process chamber 201 (after-purge step). Thereafter, the inner atmosphere of the process chamber 201 is replaced with the inert gas, and the inner pressure of the process chamber 201 is returned to the normal pressure (atmospheric pressure) (returning to atmospheric pressure step).

<Boat Unloading Step and Wafer Discharging Step>

Thereafter, the cap 219 is lowered by the elevator 115 and the lower end of the outer tube 203 is opened. The boat 217 with the wafers 200 (which are processed) charged therein is unloaded out of the outer tube 203 through the lower end of the outer tube 203 (boat unloading step). Then, the wafers 200 (which are processed) are discharged (transferred) out of the boat 217 (wafer discharging step).

(3) Effects according to Present Embodiments

According to the present embodiments, it is possible to obtain one or more of the following effects.

(a) By supplying the halogen-containing gas, it is possible to remove (etch) the metal oxide film 500 on the first film 300. In addition, it is possible to form the adsorption promoting layer 600 capable of promoting a formation of the modification layer 700 on the second film 400.

(b) By supplying the organic-containing gas, it is possible to form the modification layer 700 capable of inhibiting a film formation on the second film 400.

(c) It is possible to selectively form the metal-containing film 900 on the first film 300 (on which the modification layer 700 is not formed) on the wafer 200 including the first film 300 and the second film 400 on the surface thereof.

(d) In addition, by supplying the halogen-containing gas before the film forming step, it is possible to reduce the contact resistance between the first film 300 and the metal-containing film 900 filled in the recess.

(4) Other Embodiments

While the technique of the present disclosure is described in detail by way of the embodiments mentioned above, the technique of the present disclosure is not limited thereto. For example, the technique of the present disclosure may be modified in various ways without departing from the scope thereof. In the following modified examples, portions (features) different from that of the embodiments mentioned above will be described in detail.

<First Modified Example>

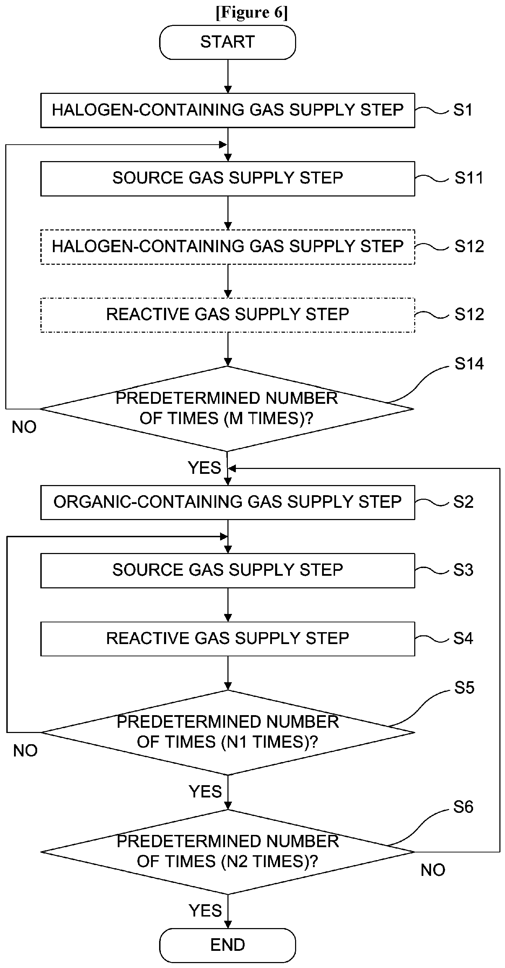

In the present modified example, as shown in FIG. 6, between the halogen-containing gas supply step (step S1) and the organic-containing gas supply step (step S2) in the substrate processing mentioned above, a source gas supply step (that is, a step S11) and a step 14 of performing the step S11 a predetermined number of times (M times, where M is an integer of 1 or more) are performed.

That is, according to the present modified example, after the halogen-containing gas supply step (step S1) described above, the source gas supply step (step S11) similar to the step S3 described above is performed the predetermined number of times (M times, where M is an integer of 1 or more) in the step S14. Then, the steps S2 to S6 described above are performed. That is, the substrate processing according to the present modified example may be illustrated as follows.

Halogen-containing gas → Source gas × M → [Organic-containing gas → (Source gas → Reactive gas) × N1] × N2

M, N1 and N2 are integers of 1 or more.

According to the present modified example, it is possible to obtain substantially same effects as those of the embodiments mentioned above. According to the present modified example, it is possible to form the metal-containing film 900 on the first film 300 while removing the metal oxide film 500 on the first film 300. In addition, it is possible to reduce an amount of the halogen element such as chlorine adsorbed on the second film 400. As the source gas used in the source gas supply step (step S11), the same metal-containing gas as the source gas used in the source gas supply step (step S3) mentioned above may be used, or a metal-containing gas different from the metal-containing gas (source gas) used in the source gas supply step (step S3) mentioned above may be used. Even in such a case, it is possible to obtain substantially same effects as those of the embodiments mentioned above. The same also applies to other modified examples described below.

<Second Modified Example>

In the present modified example, as shown in FIG. 6, between the halogen-containing gas supply step (step S1) and the organic-containing gas supply step (step S2) in the substrate processing mentioned above, the source gas supply step (step S11), a halogen-containing gas supply step (that is, a step S12) indicated by a dotted box in FIG. 6 and the step S14 of performing the step S11 and the step S12 the predetermined number of times (M times, where M is an integer of 1 or more) are performed.

That is, according to the present modified example, after the halogen-containing gas supply step (step S1) described above, the source gas supply step (step S11) similar to the step S3 described above and the halogen-containing gas supply step (step S12) similar to the step S1 described above are performed the predetermined number of times (M times, where M is an integer of 1 or more) in the step S14. Then, the steps S2 to S6 described above are performed. That is, the substrate processing according to the present modified example may be illustrated as follows.

Halogen-containing gas → (Source gas → Halogen-containing gas) × M → [Organic-containing gas → (Source gas → Reactive gas) × N1] × N2

M, N1 and N2 are integers of 1 or more.

According to the present modified example, it is possible to obtain substantially same effects as those of the embodiments and the modified example mentioned above.

<Third Modified Example>

In the present modified example, as shown in FIG. 6, between the halogen-containing gas supply step (step S1) and the organic-containing gas supply step (step S2) in the substrate processing mentioned above, the source gas supply step (step S11), a reactive gas supply step (that is, a step S13 indicated by a dashed dotted box in FIG. 6 and the step 14 of performing the step S11 and the step S13 the predetermined number of times (M times, where M is an integer of 1 or more) are performed.

That is, according to the present modified example, after the halogen-containing gas supply step (step S1) described above, the source gas supply step (step S11) similar to the step S3 described above and the reactive gas supply step (step S13) similar to the step S4 described above are performed the predetermined number of times (M times, where M is an integer of 1 or more) in the step S14. Then, the steps S2 to S6 described above are performed. That is, the substrate processing according to the present modified example may be illustrated as follows.

Halogen-containing gas → (Source gas → Reactive gas) × M → [Organic-containing gas → (Source gas → Reactive gas) × N1] × N2

M, N1 and N2 are integers of 1 or more.

According to the present modified example, it is possible to obtain substantially same effects as those of the embodiments and the modified examples mentioned above. In addition, it is preferable to perform the steps S11 and S13 mentioned above in this order. Thereby, it is possible to prevent the halogen element on the second film 400 from being removed excessively. In other words, by keeping the halogen element adsorbed on the second film 400, it is possible selectively form the metal-containing film on the first film 300 on which the halogen element is not adsorbed.

<Fourth Modified Example>

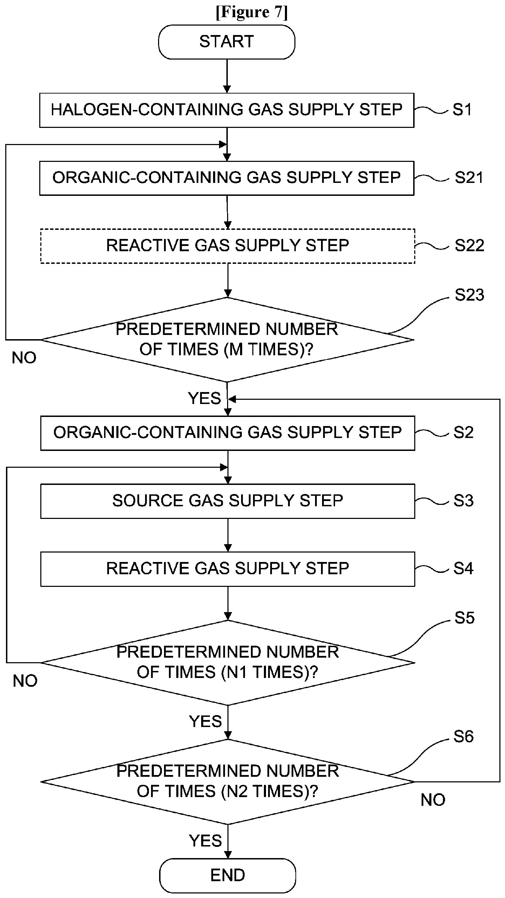

In the present modified example, as shown in FIG. 7, between the halogen-containing gas supply step (step S1) and the organic-containing gas supply step (step S2) in the substrate processing mentioned above, an organic-containing gas supply step (that is, a step S21) and a step 23 of performing the step S21 a predetermined number of times (M times, where M is an integer of 1 or more) are performed.

That is, according to the present modified example, after the halogen-containing gas supply step (step S1) described above, the organic-containing gas supply step (step S21) similar to the step S2 described above is performed the predetermined number of times (M times, where M is an integer of 1 or more) in the step S23. Then, the steps S2 to S6 described above are performed. That is, the substrate processing according to the present modified example may be illustrated as follows.

Halogen-containing gas → Organic-containing gas × M → [Organic-containing gas → (Source gas → Reactive gas) × N1] × N2

M, N1 and N2 are integers of 1 or more.

According to the present modified example, it is possible to obtain substantially same effects as those of the embodiments mentioned above. In addition, according to the present modified example, by further performing the supply of the organic-containing gas (that is, the step S21) M times, it is possible to form the modification layer 700 on the second film 400 while removing the reaction by-products. In other words, it is possible to reduce the amount of the halogen element such as chlorine adsorbed on the second film 400.

<Fifth Modified Example>

In the present modified example, as shown in FIG. 7, between the halogen-containing gas supply step (step S1) and the organic-containing gas supply step (step S2) in the substrate processing mentioned above, the organic-containing gas supply step (S21), a reactive gas supply step (that is, a step S22) indicated by a dotted box in FIG. 7 and the step 23 of performing the step S21 and the step S22 the predetermined number of times (M times, where M is an integer of 1 or more) are performed.

That is, according to the present modified example, after the halogen-containing gas supply step (step S1) described above, the organic-containing gas supply step (step S21) similar to the step S2 described above and the reactive gas supply step (step S22) similar to the step S4 described above are performed the predetermined number of times (M times, where M is an integer of 1 or more) in the step S23. Then, the steps S2 to S6 described above are performed. That is, the substrate processing according to the present modified example may be illustrated as follows.

Halogen-containing gas → (Organic-containing gas → Reactive gas) × M → [Organic-containing gas → (Source gas → Reactive gas) × N1] × N2

M, N1 and N2 are integers of 1 or more.

According to the present modified example, it is possible to obtain substantially same effects as those of the embodiments and the modified examples mentioned above.

For example, the embodiments mentioned above are described by way of an example in which, in the halogen-containing gas supply step (step S1) in the substrate processing mentioned above, the adsorption promoting layer 600 is formed on the second film 400 while removing the metal oxide film 500 formed on the first film 300 on the wafer 200. However, the technique of the present disclosure is not limited thereto. For example, a step of removing the metal oxide film 500 may be provided before the halogen-containing gas supply step (step S1), separately from the step S1. In such a case, as a gas used in the step of removing the metal oxide film 500 before the halogen-containing gas supply step (step S1), the same halogen-containing gas used in the step S1 mentioned above may be used, or a halogen-containing gas such as a fluorine (F)-based gas different from the halogen-containing gas used in the step S1 mentioned above may be used. Even in such a case, it is possible to obtain substantially same effects as those of the embodiments mentioned above.

For example, the embodiments mentioned above are described by way of an example in which a predetermined film is formed on the wafer 200. However, the technique of the present disclosure is not limited thereto. For example, the technique of the present disclosure is not limited to a particular type of the film.

For example, the embodiments mentioned above are described by way of an example in which a batch type substrate processing apparatus capable of simultaneously processing a plurality of substrates is used to form the film. However, the technique of the present disclosure is not limited thereto. For example, the technique of the present disclosure may be preferably applied when a single wafer type substrate processing apparatus capable of processing one or several substrates at once is used to form the film. For example, the embodiments mentioned above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film.

For example, the embodiments mentioned above are described by way of an example in which the substrate processing (process sequence) mentioned above is performed in the same process chamber of the same substrate processing apparatus (that is, in-situ). However, the technique of the present disclosure is not limited thereto. For example, a step in the process sequence mentioned above and another step in the process sequence mentioned above may be performed in different process chambers of different substrate processing apparatuses (that is, ex-situ), or may be performed in different process chambers of the same substrate processing apparatus.

The process procedures and the process conditions of each process using the substrate processing apparatuses exemplified above may be substantially the same as those of the embodiments or the modified examples mentioned above. Even in such a case, it is possible to obtain substantially the same effects as in the embodiments or the modified examples mentioned above.

It is preferable that the recipe (that is, a program defining parameters such as the process procedures and the process conditions of the substrate processing) used to form each type of film is prepared individually in accordance with the contents of the substrate processing such as a type of the film to be formed, a composition ratio of the film, a quality of the film, a thickness of the film, the process procedures and the process conditions of the substrate processing. For example, it is preferable that a plurality of recipes are stored (installed) in the memory 121c in advance via an electric communication line or the external memory 123. Then, when starting the substrate processing, the CPU 121a preferably selects the appropriate recipe among the recipes stored in the memory 121c in accordance with the contents of the substrate processing. With such a configuration, various films of different types, different composition ratios, different qualities and different thicknesses may be formed with a high reproducibility using a single substrate processing apparatus. In addition, since a burden on an operator such as inputting the process procedures and the process conditions may be reduced, various processes (that is, the substrate processing) can be performed quickly while avoiding a misoperation of the substrate processing apparatus 10.

The recipe (process recipe) described above is not limited to creating a new recipe. For example, the recipe may be prepared by changing an existing recipe stored in the substrate processing apparatus in advance. When changing the existing recipe to a new recipe, the new recipe may be installed in the substrate processing apparatus via the electric communication line or the recording medium in which the new recipe is stored. For example, the existing recipe already stored in the substrate processing apparatus may be directly changed to the new recipe by operating the input/output device 122 of the substrate processing apparatus.

The invention may be summarized as follow: It is possible to selectively form a metal-containing film starting from a specific region on a substrate. There is provided a technique that includes: (a) forming an adsorption promoting layer capable of promoting an adsorption of an organic-containing agent on a substrate by supplying a halogen-containing agent to the substrate; (b) forming a modification layer on the substrate by supplying the organic-containing agent to the substrate; (c) supplying a source material containing a metal element to the substrate; (d) supplying a reactant to the substrate; and (e) forming a metal-containing film in a region of the substrate where the modification layer is not formed, by performing (b), (c) and (d) N times after (a).

For example, the embodiments and the modified examples mentioned above may be appropriately combined with each other. The process procedures and the process conditions of each combination thereof may be substantially the same as those of the embodiments or the modified examples mentioned above.

[Description of Reference Numerals]

200     wafer (substrate)
600     adsorption promoting layer
700     modification layer
900     metal-containing film

**Claims**

1. A substrate processing method comprising:

   (a) forming an adsorption promoting layer capable of promoting an adsorption of an organic-containing agent on a substrate by supplying a halogen-containing agent to the substrate;
   (b) forming a modification layer on the substrate by supplying the organic-containing agent to the substrate;
   (c) supplying a source material containing a metal element to the substrate;
   (d) supplying a reactant to the substrate; and
   (e) forming a metal-containing film in a region of the substrate where the modification layer is not formed, by performing (b), (c) and (d) N times after (a).

2. The substrate processing method of claim 1, wherein, in (e), (c) is performed M times after (a), and then (b), (c) and (d) are performed N times, and wherein M is an integer of two or more.

3. The substrate processing method of claim 1, wherein, in (e), (c) and (a) are performed M times after (a), and then (b), (c) and (d) are performed N times.

4. The substrate processing method of claim 1, wherein, in (e), (c) and (d) are performed M times after (a), and then (b), (c) and (d) are performed N times, and wherein, in (e), (c) and (d) are performed sequentially in this order.

5. The substrate processing method of claim 1, wherein, in (e), (b) is performed M times after (a), and then (b), (c) and (d) are performed N times.

6. The substrate processing method of claim 1, wherein, in (e), (b) and (d) are performed M times after (a), and then (b), (c) and (d) are performed N times.

7. The substrate processing method of claim 1, wherein in (e), (b), (c) and (d) are performed sequentially in this order.

8. The substrate processing method of any one or more of claims 1 to 7, wherein the substrate comprises a metal oxide film and a non-metal oxide film, and
   wherein, in (a), the adsorption promoting layer is formed on the non-metal oxide film.

9. The substrate processing method of any one or more of claims 1 to 8, wherein the halogen-containing agent contains one of a Group 14 element, a Group 15 element and a Group 16 element.

10. The substrate processing method of any one or more of claims 1 to 8, wherein the halogen-containing agent contains an oxyhalide.

11. The substrate processing method of any one or more of claims 1 to 10, wherein the organic-containing agent contains one or more amino groups and two or more alkyl groups.

12. The substrate processing method of any one or more of claims 1 to 11, further comprising

    (f) removing a metal oxide film before (a),
    wherein the metal oxide film is formed on the substrate before (a).

13. A method of manufacturing a semiconductor device, comprising:
    the substrate processing method of any one or more of claims 1 to 12.

14. A substrate processing apparatus comprising:

    a first supplier configured to supply a source material containing a metal element to a substrate;

a second supplier configured to supply a reactant to the substrate;

a third supplier configured to supply an organic-containing agent to the substrate;

a fourth supplier configured to supply a halogen-containing agent to the substrate; and

a controller configured to be capable of controlling the first supplier, the second supplier, the third supplier and the fourth supplier to perform:

(a) forming an adsorption promoting layer capable of promoting an adsorption of the organic-containing agent on the substrate by supplying the halogen-containing agent to the substrate;

(b) forming a modification layer on the substrate by supplying the organic-containing agent to the substrate;

(c) supplying the source material containing the metal element to the substrate;

(d) supplying the reactant to the substrate; and

(e) forming a metal-containing film in a region of the substrate where the modification layer is not formed, by performing (b), (c) and (d) N times after (a).

15. A program that causes a substrate processing apparatus, by a computer, to perform:

(a) forming an adsorption promoting layer capable of promoting an adsorption of an organic-containing agent on a substrate by supplying a halogen-containing agent to the substrate;

(b) forming a modification layer on the substrate by supplying the organic-containing agent to the substrate;

(c) supplying a source material containing a metal element to the substrate;

(d) supplying a reactant to the substrate; and

(e) forming a metal-containing film in a region of the substrate where the modification layer is not formed, by performing (b), (c) and (d) N times after (a).

[Figure 1]

[Figure 2]

[Figure 3]

START

HALOGEN-CONTAINING GAS SUPPLY STEP ⟶ S1

ORGANIC-CONTAINING GAS SUPPLY STEP ⟶ S2

SOURCE GAS SUPPLY STEP ⟶ S3

REACTIVE GAS SUPPLY STEP ⟶ S4

PREDETERMINED NUMBER
OF TIMES (N1 TIMES)? ⟶ S5

NO

YES

PREDETERMINED NUMBER
OF TIMES (N2 TIMES)? ⟶ S6

NO

YES

END

[Figure 4]

900

400

500

300

200

[Figure 5A]

500

300    400

200

[Figure 5B]

600

300    400

200

[Figure 5C]

700

300    400

200

[Figure 5D]

800        700

300    400

200

[Figure 5E]

900        700

300    400

200

[Figure 6]

```
                    ┌─────────────┐
                    │    START    │
                    └─────────────┘
                           │
                           ▼
        ┌──────────────────────────────────────┐
        │ HALOGEN-CONTAINING GAS SUPPLY STEP    │──～ S1
        └──────────────────────────────────────┘
                           │
          ┌────────────────┤
          │                ▼
          │    ┌──────────────────────────────┐
          │    │   SOURCE GAS SUPPLY STEP      │──～ S11
          │    └──────────────────────────────┘
          │                │
          │                ▼
          │    ┌ ─ ─ ─ ─ ─ ─ ─ ─ ─ ─ ─ ─ ─ ─ ┐
          │    │ HALOGEN-CONTAINING GAS SUPPLY STEP │──～ S12
          │    └ ─ ─ ─ ─ ─ ─ ─ ─ ─ ─ ─ ─ ─ ─ ┘
          │                │
          │                ▼
          │    ┌ ─ · ─ · ─ · ─ · ─ · ─ · ─ · ┐
          │    │   REACTIVE GAS SUPPLY STEP   │──～ S12
          │    └ ─ · ─ · ─ · ─ · ─ · ─ · ─ · ┘
          │                │                         ～ S14
          │                ▼
          │        ╱───────────────────╲
          │       ╱  PREDETERMINED NUMBER ╲
          └──────◄   OF TIMES (M TIMES)?   ►
             NO   ╲                       ╱
                   ╲─────────────────────╱
                           │ YES
                           ▼
        ┌──────────────────────────────────────┐
        │ ORGANIC-CONTAINING GAS SUPPLY STEP    │──～ S2
        └──────────────────────────────────────┘
                           │
          ┌────────────────┤
          │                ▼
          │    ┌──────────────────────────────┐
          │    │   SOURCE GAS SUPPLY STEP      │──～ S3
          │    └──────────────────────────────┘
          │                │
          │                ▼
          │    ┌──────────────────────────────┐
          │    │   REACTIVE GAS SUPPLY STEP    │──～ S4
          │    └──────────────────────────────┘
          │                │                         ～ S5
          │                ▼
          │        ╱───────────────────╲
          │       ╱  PREDETERMINED NUMBER ╲
          └──────◄   OF TIMES (N1 TIMES)?  ►
             NO   ╲                       ╱
                   ╲─────────────────────╱
                           │ YES
                           ▼                         ～ S6
                   ╱───────────────────╲
                  ╱  PREDETERMINED NUMBER ╲
                 ◄   OF TIMES (N2 TIMES)?  ►──── NO
                  ╲                       ╱
                   ╲─────────────────────╱
                           │ YES
                           ▼
                    ┌─────────────┐
                    │     END     │
                    └─────────────┘
```

[Figure 7]

```
                      ┌─────────────┐
                      │    START    │
                      └─────────────┘
                             │
                             ▼
         ┌──────────────────────────────────────┐
         │  HALOGEN-CONTAINING GAS SUPPLY STEP   │───S1
         └──────────────────────────────────────┘
                             │
         ┌───────────────────┤
         │                   ▼
         │   ┌──────────────────────────────────────┐
         │   │  ORGANIC-CONTAINING GAS SUPPLY STEP   │───S21
         │   └──────────────────────────────────────┘
         │                   │
         │                   ▼
         │   ┌╌╌╌╌╌╌╌╌╌╌╌╌╌╌╌╌╌╌╌╌╌╌╌╌╌╌╌╌╌╌╌╌╌╌╌╌╌╌┐
         │   ╎      REACTIVE GAS SUPPLY STEP        ╎───S22
         │   └╌╌╌╌╌╌╌╌╌╌╌╌╌╌╌╌╌╌╌╌╌╌╌╌╌╌╌╌╌╌╌╌╌╌╌╌╌╌┘
         │                   │
         │                   ▼                        S23
         │            ◇────────────────◇
         └── NO ──────PREDETERMINED NUMBER
                      OF TIMES (M TIMES)?
                     ◇────────────────◇
                             │ YES ◄──────────────────┐
                             ▼                         │
         ┌──────────────────────────────────────┐     │
         │  ORGANIC-CONTAINING GAS SUPPLY STEP   │───S2│
         └──────────────────────────────────────┘     │
                             │                         │
         ┌───────────────────┤                         │
         │                   ▼                         │
         │   ┌──────────────────────────────────────┐ │
         │   │        SOURCE GAS SUPPLY STEP         │─│─S3
         │   └──────────────────────────────────────┘ │
         │                   │                         │
         │                   ▼                         │
         │   ┌──────────────────────────────────────┐ │
         │   │       REACTIVE GAS SUPPLY STEP        │─│─S4
         │   └──────────────────────────────────────┘ │
         │                   │                         │
         │                   ▼                   S5    │
         │            ◇────────────────◇              │
         └── NO ──────PREDETERMINED NUMBER            │
                      OF TIMES (N1 TIMES)?            │
                     ◇────────────────◇              │
                             │ YES                     │
                             ▼                   S6    │
                      ◇────────────────◇              │
                      PREDETERMINED NUMBER ──── NO ────┘
                      OF TIMES (N2 TIMES)?
                     ◇────────────────◇
                             │ YES
                             ▼
                      ┌─────────────┐
                      │     END     │
                      └─────────────┘
```

Europäisches
Patentamt

European
Patent Office

Office européen
des brevets

# EUROPEAN SEARCH REPORT

**Application Number**

EP 25 16 6724

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/048762 A1 (KE CHANG [US] ET AL) 13 February 2020 (2020-02-13) * paragraph [0017] - paragraph [0022] * * paragraph [0026] * * paragraph [0033] - paragraph [0034] * * figures 1-3 * | 1-15 | INV. C23C16/02 C23C16/04 C23C16/18 C23C16/455 |
| A | US 2022/301882 A1 (TAKATSUKI KOICHI [JP] ET AL) 22 September 2022 (2022-09-22) * paragraph [0045] - paragraph [0048] * * paragraph [0071] - paragraph [0073] * * figures 3, 4, 5A, 5B * | 11 | |
| A | WO 2022/243274 A1 (MERCK PATENT GMBH [DE]) 24 November 2022 (2022-11-24) * paragraph [0017] * * paragraph [0111] - paragraph [0115] * * figure 1 * | 9,10 | |
| A | EP 4 195 238 A1 (KOKUSAI ELECTRIC CORP [JP]) 14 June 2023 (2023-06-14) * paragraph [0032] - paragraph [0034] * * paragraph [0041] * * paragraph [0056] * * paragraph [0069] - paragraph [0070] * * paragraph [0135] * * figures 4, 5, 6A, 6B, 6C * | 1-15 | TECHNICAL FIELDS SEARCHED (IPC) C23C |

The present search report has been drawn up for all claims

| Place of search | Date of completion of the search | Examiner |
|---|---|---|
| The Hague | 29 August 2025 | Fertig, Andrea |

EPO FORM 1503 03.82 (P04C01)

## ANNEX TO THE EUROPEAN SEARCH REPORT
## ON EUROPEAN PATENT APPLICATION NO.

EP 25 16 6724

This annex lists the patent family members relating to the patent documents cited in the above-mentioned European search report.
The members are as contained in the European Patent Office EDP file on
The European Patent Office is in no way liable for these particulars which are merely given for the purpose of information.

29-08-2025

| Patent document cited in search report | Publication date | Patent family member(s) | | Publication date |
|---|---|---|---|---|
| US 2020048762 A1 | 13-02-2020 | CN | 112567498 A | 26-03-2021 |
| | | JP | 7189321 B2 | 13-12-2022 |
| | | JP | 2021533272 A | 02-12-2021 |
| | | KR | 20210031530 A | 19-03-2021 |
| | | TW | 202009318 A | 01-03-2020 |
| | | US | 2020048762 A1 | 13-02-2020 |
| | | US | 2024352577 A1 | 24-10-2024 |
| | | WO | 2020033698 A1 | 13-02-2020 |
| US 2022301882 A1 | 22-09-2022 | JP | 7336884 B2 | 01-09-2023 |
| | | JP | 2020059916 A | 16-04-2020 |
| | | KR | 20200038854 A | 14-04-2020 |
| | | US | 2022301882 A1 | 22-09-2022 |
| WO 2022243274 A1 | 24-11-2022 | CN | 117377790 A | 09-01-2024 |
| | | JP | 2024519862 A | 21-05-2024 |
| | | KR | 20240008886 A | 19-01-2024 |
| | | TW | 202306963 A | 16-02-2023 |
| | | US | 2025003058 A1 | 02-01-2025 |
| | | WO | 2022243274 A1 | 24-11-2022 |
| EP 4195238 A1 | 14-06-2023 | CN | 116246942 A | 09-06-2023 |
| | | EP | 4195238 A1 | 14-06-2023 |
| | | JP | 7426978 B2 | 02-02-2024 |
| | | JP | 2023085081 A | 20-06-2023 |
| | | KR | 20230086602 A | 15-06-2023 |
| | | TW | 202329244 A | 16-07-2023 |
| | | US | 2023175116 A1 | 08-06-2023 |

EPO FORM P0459

For more details about this annex : see Official Journal of the European Patent Office, No. 12/82

**EP 4 636 124 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2023073924 A